# EUROPEAN PATENT APPLICATION

(11) **EP 4 496 140 A1**
(43) Date of publication of application: **22.01.2025**
(21) Application number: 23769747.9
(22) Date of filing: 14.03.2023
(51) Int. Cl.: H01R 31/06, H01R 13/73, H01R 13/6581, H01R 13/405, H01B 7/42, H01B 7/04, H01B 7/18, H01B 7/40, B60L 53/16

(54) **CONNECTOR ASSEMBLY HAVING LIQUID COOLING FUNCTION, AND VEHICLE**

(30) Priority: 14.03.2022 CN 202210250055
(71) Applicant: Changchun Jetty Automotive Technology Co., Ltd., Changchun City, Jilin Province 130000 (CN)
(72) Inventor: WANG, Chao, Changchun, Jilin 130000 (CN)
(74) Representative: Habermann, Hruschka & Schnabel
(86) International application number: PCT/CN2023/081258
(87) International publication number: WO 2023/174245

(57) **Abstract**

A connector assembly having a liquid cooling function and a vehicle. The connector assembly includes at least one electrical connection framework and a connector that includes a connection terminal. Two ends of the electrical connection framework are electrically connected to the connection terminal respectively, and the electrical connection framework is provided with at least one hollow inner cavity, through which a cooling liquid flows. The connector assembly adopts the liquid cooling technology to reduce the heat generation amount of the electrical connection framework, so that the electrical connection framework can conduct a large current with a small wire diameter to ensure the normal use of the high-voltage device.

## Description

### RELATED APPLICATION

The present disclosure claims priority to Chinese Patent Application No. 202210250055.2, entitled "connector assembly having liquid cooling function, and vehicle", and filed to the China National Intellectual Property Administration on March 14, 2022, which is hereby incorporated by reference in its entirety.

### TECHNICAL FIELD

The present disclosure relates to the technical field of vehicle electrical appliances, and particularly to a connector assembly having a liquid cooling function, and a vehicle.

### BACKGROUND

With the increasing popularity of new energy vehicles, the equipment and facilities for conducting current for the new energy vehicles have also been developed. Since a connector assembly on a new energy vehicle has to meet the requirement of driving a high-power motor, the transmission current is large, and the diameter of a high-voltage cable on the connector assembly also increases, such that the assembling on a vehicle body can only adopt manual mounting, which causes the wastes of a labor cost and a time cost.

In addition, during normal use, a very large current flows through the high-voltage cable, such that a lot of heat is generated in both the high-voltage cable and a connector. A high temperature will occur due to excessive heat, and the connection position of the high-voltage cable and the surrounding connectors and fasteners will be failed due to the high temperature, which will affect the normal use of a high-voltage device, resulting in short circuit and open circuit, and even the danger of electric shock that is life-threatening.

Currently, there is no practical solution to the above problems. Therefore, the technical field of vehicle electrical appliances is in urgent need of a connector assembly with a small wire diameter and a low cable heat generation amount, which can realize automatic production and assembling.

### SUMMARY

The present disclosure aims to provide new technical solutions of a connector assembly having a liquid cooling function and a vehicle. The connector assembly having a liquid cooling function of the present disclosure can reduce the failures of an electrical connection framework and a connection terminal caused by a high temperature during electrification, prolong a service life of a connector, and improve the safety of the whole vehicle.

According to a first aspect of the present disclosure, there is provided a connector assembly having a liquid cooling function, including at least one electrical connection framework and connectors. Each connector includes a connection terminal, two ends of the electrical connection framework are electrically connected to the connection terminals respectively, and the electrical connection framework is provided with at least one hollow inner cavity through which a cooling liquid flows.

Optionally, the cooling liquid is made of an insulating material.

Optionally, the electrical connection framework includes a rigid hollow conductor.

Optionally, the electrical connection framework is electrically connected to the connection terminal by means of welding or crimping.

Optionally, a cross-sectional shape of an outer contour of the electrical connection framework is one or more selected from the group consisting of a circular shape, an elliptical shape, a rectangular shape, a polygonal shape, an A shape, a B shape, a D shape, an M shape, an N shape, an O shape, an S shape, an E shape, an F shape, an H shape, a K shape, an L shape, a T shape, a U shape, a V shape, a W shape, an X shape, a Y shape, a Z shape, a P shape, a semi-arc shape, an arc shape and a wavy shape.

Optionally, when the electrical connection framework is provided with one hollow inner cavity, the hollow conductor has a uniform wall thickness.

Optionally, a cross-sectional area of the hollow conductor material is 1.5 mm² to 240 mm².

Optionally, a sum of cross-sectional area of the at least one hollow inner cavity accounts for 3.7% to 75% of a cross-sectional area of a circumscribed circle of the electrical connection framework.

Optionally, the connector further includes a shielding inner shell, and a material of the shielding inner shell contains a conductive material.

Optionally, a material of the shielding inner shell contains metal or conductive plastic.

Optionally, the conductive plastic is a polymer material containing conductive particles, and the conductive particles are made of a material containing one or more selected from the group consisting of metal, conductive ceramics, a carbon-containing conductor, a solid electrolyte and a mixed conductor. The polymer material contains one or more selected from the group consisting of tetraphenyl ethylene, polyvinyl chloride, polyethylene, polyamide, polytetrafluoroethylene, tetrafluoroethylene/hexafluoropropylene copolymer, ethylene/tetrafluoroethylene copolymer, polypropylene, polyvinylidene fluoride, polyurethane, polyterephthalic acid, polyurethane elastomer, styrene block copolymer, perfluoroalkoxy alkane, chlorinated polyethylene, polyphenylene sulfide, polystyrene, cross-linked polyolefin, ethylene-propylene rubber, ethylene/vinyl acetate copolymer, chloroprene rubber, natural rubber, styrene butadiene rubber, nitrile rubber, silicone rubber, butadiene rubber, isoprene rubber, ethylene propylene rubber, chloroprene rubber, butyl rubber, fluororubber, polyurethane rubber, polyacrylate rubber, chlorosulfonated polyethylene rubber, epichlorohydrin rubber, chlorinated polyethylene rubber, chlorosulfide rubber, styrene butadiene rubber, butadiene rubber, hydrogenated nitrile rubber, polysulfide rubber, crosslinked polyethylene, polycarbonate, polysulfone, polyphenyl ether, polyester, phenolic resin, urea formaldehyde, styrene-acrylonitrile copolymer, polymethacrylate, and polyoxymethylene resin.

Optionally, a material of the metal contains one or more selected from the group consisting of nickel, cadmium, zirconium, chromium, cobalt, manganese, aluminum, tin, titanium, zinc, copper, silver, gold, phosphorus, tellurium and beryllium.

Optionally, the carbon-containing conductor contains one or more selected from the group consisting of graphite silver, graphene silver, graphite powder, a carbon nanotube material and a graphene material.

Optionally, a transfer impedance of the shielding layer is less than 100 mΩ.

Optionally, an outer periphery of the electrical connection framework is sleeved with an insulation layer.

Optionally, an outer periphery of the electrical connection framework is sleeved with an insulation layer, and an outer periphery of the insulation layer is further sleeved with a shielding layer and an outer insulation layer.

Optionally, the shielding layer is electrically connected to the shielding inner shell.

Optionally, the connector includes a first connector and a second connector which are connected to two ends of the electrical connection framework; the first connector is internally provided with a rotary cavity, the second connector is internally provided with an adapter cavity, and the rotary cavity and the adapter cavity are communicated with the hollower inner cavity, respectively; one of the first connector and the second connector is provided with an inlet pipe, which is communicated with one of the rotary cavity and the adapter cavity; and the other of the first connector and the second connector is provided with an outlet pipe, which is communicated with the other of the rotary cavity and the adapter cavity.

Optionally, a part of the electrical connection framework inside the rotary cavity and a part thereof inside the adapter cavity are both radially provided with through holes, via which the cooling liquid flows through the rotary cavity, the hollow inner cavity and the adapter cavity.

Optionally, the inlet pipe and the outlet pipe each has one end in matched connection with the through hole, and the other end passing through outer walls of the first connector and the second connector and protruding out of the first connector and the second connector.

Optionally, a first sealing structure is disposed between the inlet pipe and one of the first connector and the second connector; and a second sealing structure is disposed between the outlet pipe and the other one of the first connector and the second connector.

Optionally, a boiling point of the cooling liquid is greater than or equal to 100°C.

Optionally, the cooling liquid is one or more selected from the group consisting of ethylene glycol, silicone oil, fluoride, castor oil, coconut oil, corn oil, cottonseed oil, linseed oil, olive oil, palmitic acid, peanut oil, grapeseed oil, rapeseed oil, safflower oil, sunflower oil, soybean oil, high oleic acid variants of various vegetable oils, decen-4-oic acid, decenoic acid, lauroleic acid, linderic acid, tetradecenoic acid, physeteric acid, tsuduic acid, palmitoleic acid, petroselic acid, oleic acid, octadecenoic acid, gadoleic acid, gondoic acid, cetoleic acid, erucic acid, nervonic acid, glycerin, transformer oil, axle oil, internal combustion engine oil and compressor oil.

Optionally, a cooling rate of the cooling liquid to the electrical connection framework is 0.05 K/s to 5 K/s.

Optionally, one of the connectors is a charging cradle.

Optionally, a partial region of the electrical connection framework is flexible.

Optionally, the electrical connection framework includes at least one bent portion.

According to a second aspect of the present disclosure, there is provided a vehicle, including the connector assembly having a liquid cooling function according to any one of the above embodiments, a circulating pump and a cooling device, and the hollower inner cavity is communicated with the circulating pump and the cooling device.

Optionally, an inlet pipe in communication with the hollow inner cavity is communicated with a liquid inlet of the circulating pump, a liquid outlet of the circulating pump is communicated with a liquid inlet of the cooling device, and a liquid outlet of the cooling device is communicated with an outlet pipe that is communicated with the hollow inner cavity.

The present disclosure has the following advantageous effects:
1. The present disclosure solves the problem that the wire diameter of the high-voltage wire harness at present is large. The liquid cooling technology is used to reduce the heat generation amount of the electrical connection framework, so that the electrical connection framework can conduct a large current with a small wire diameter.
2. The present disclosure solves the problem that the automatic production and assembling cannot be realized due to the use of flexible cables for the high-voltage wire harnesses at present. The automatic fitting and assembling of the wire harness can be realized using the electrical connection framework which is at least partially rigid.
3. The present disclosure solves the problem of the low cooling efficiency of a liquid-cooled wire harness at present. The liquid-cooled wire harness is cooled through a liquid cooling pipe at present, while in the present disclosure, the cooling liquid directly contacts the electrical connection framework, so that the temperature of the electrical connection framework can be quickly decreased, and a high current conduction can be realized.
4. The present disclosure solves the problem that the flexible cable contacts and rubs a vehicle shell, which cause the damage and short circuit of the insulation layer. The electrical connection framework can be arranged according to the shape of a vehicle body, while keeping a distance from the vehicle body to avoid rubbing the vehicle shell, thereby ensuring the service life of the electrical connection framework.
5. The connector is provided with a shielding inner shell, which can effectively prevent the electromagnetic interference generated by the terminal of the connector. The shielding inner shell made of conductive plastic can be integrally formed with the connector by means of integral injection molding, which saves the machining time, improves the production efficiency and reduces the production cost.
6. The electrical connection framework includes a flexible portion and a bent portion, so that the structure of the connector assembly can be reasonably designed according to the mounting environment of the vehicle body, which makes the mounting of the connector assembly on the vehicle body easier and saves the assembling time.

### BRIEF DESCRIPTION OF THE DRAWINGS

The drawings, which are incorporated in and constitute a part of the specification, illustrate the embodiments of the present disclosure and together with the description, serve to explain the principles of the present disclosure.
FIG. 1 illustrates a structural diagram of a connector assembly having a liquid cooling function according to the present disclosure.
FIG. 2 illustrates a cross-sectional view of an electrical connection framework according to a first embodiment of the present disclosure.
FIG. 3 illustrates a cross-sectional view of an electrical connection framework according to a second embodiment of the present disclosure.
FIG. 4 illustrates a cross-sectional view of an electrical connection framework according to a third embodiment of the present disclosure.
FIG. 5 illustrates a cross-sectional view of an electrical connection framework according to a fourth embodiment of the present disclosure.
FIG. 6 illustrates a cross-sectional view of an electrical connection framework according to a fifth embodiment of the present disclosure.
FIG. 7 illustrates a structural diagram of connections between an electrical connection framework and a first connector and between an electrical connection framework and a second connector of a connector assembly having a liquid cooling function according to an exemplary embodiment of the present disclosure.

Reference numerals of the main components:
11-first connector; 12-second connector; 2-electrical connection framework; 3-hollow inner cavity; 4-shielding inner shell; 5-shielding layer; 14-insulation layer; 6-cavity; 7-connection terminal; 8-sealing ring; 91-inlet pipe; 92-outlet pipe; 93-through hole; 94-rotary cavity; 95-adapter cavity; 13-outer insulation layer.

### DETAILED DESCRIPTION OF THE EMBODIMENTS

Various exemplary embodiments of the present disclosure will now be described in detail with reference to the drawings. It should be noted that the relative arrangements, the numerical expressions and the numerical values of components and steps set forth in these embodiments do not limit the scope of the present disclosure unless otherwise specified.

The following description of at least one exemplary embodiment is merely illustrative and is in no way intended to limit the present disclosure or the application or the use thereof.

Technologies, methods and devices known to those of ordinary skill in the art may not be discussed in detail, but they should be regarded as parts of the specification under appropriate circumstances.

In all examples illustrated and discussed here, any specific value should be interpreted as illustrative only rather than limiting. Thus, other examples of the exemplary embodiments may have different values.

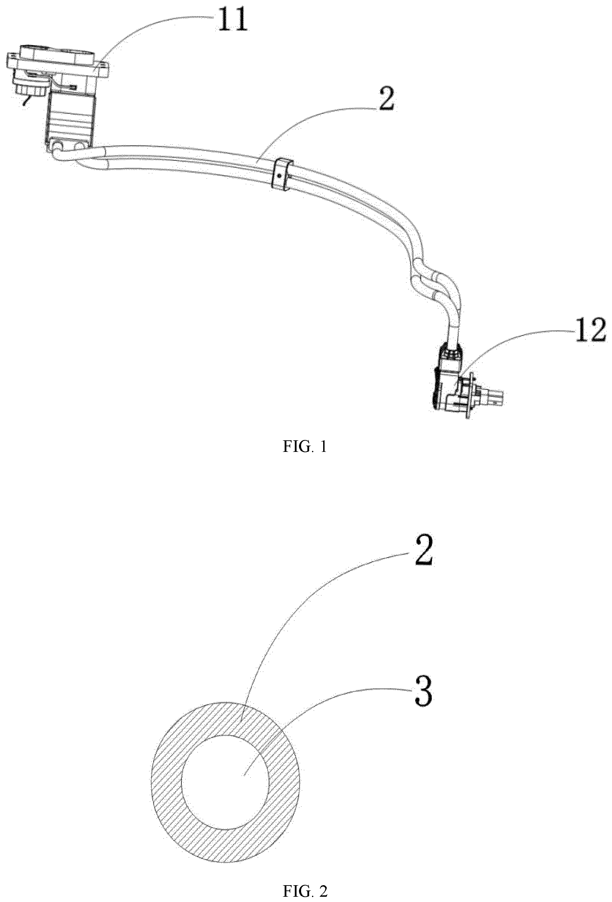

A connector assembly having a liquid cooling function, as illustrated in FIGS. 1 to 7, includes at least one electrical connection framework 2 and connectors. Each connector includes a connection terminal 7. Two ends of the electrical connection framework 2 are electrically connected to the connection terminals 7 respectively. The electrical connection framework 2 is provided with at least one hollow inner cavity 3 through which a cooling liquid flows. In a specific embodiment, the connector assembly having a liquid cooling function includes two electrical connection frameworks 2, the connector includes a first connector 11 and a second connector 12 each including the connection terminal 7, to which two ends of each of the electrical connection frameworks 2 are electrically connected, respectively. In some embodiments, one of the connectors may be a charging cradle. Exemplarily, the cooling liquid is made of an insulation material.

Therefore, by adopting the liquid cooling technology, the connector assembly having a liquid cooling function of the present disclosure not only solves the problem that the wire diameter of the high-voltage wire harness at present is large, but also reduces the heat generation amount of the electrical connection framework, so that the electrical connection framework can conduct a large current with a small wire diameter. In addition, the present disclosure also solves the problem of the low cooling efficiency of a liquid-cooled wire harness at present. In the prior art, the liquid-cooled wire harness is cooled through a liquid-cooled pipe, while in the present disclosure, the cooling liquid directly contacts the electrical connection framework, so that the temperature of the electrical connection framework can be quickly decreased, and a high current conduction can be realized.

At present, the high-voltage cables on most of the connector assemblies use multi-core copper cables, which are heavy and expensive and become an obstacle to the popularization of new energy vehicles. In addition, although the multi-core cable is soft and can be easily machined and wired, the wire diameter is too large and the weight is heavy. During travelling of the vehicle, the cable will frequently rub a vehicle shell, thereby damaging the insulation layer of the cable and resulting in a high-voltage discharge, which will damage the vehicle or cause serious traffic accidents in severe cases.

Aluminum has become one of the main materials to replace the copper cable because the electrical conductivity of aluminum is second only to that of copper, and the aluminum resources have a large storage capacity and a low price. In addition, the multi-core cable structure may be replaced by the cable form of the electrical connection framework 2, such that the cable can be fixed on the vehicle shell, without rubbing the vehicle shell along with the vibration of the vehicle, thereby prolonging the service life of the connector assembly and reducing the accident rate.

However, since the electrical conductivity of the aluminum cable is not as good as that of the copper cable, it is necessary to increase the cross-sectional area of the cable to ensure the normal current value. As a result, the diameter of the aluminum cable is larger, which occupies a larger space during machining and mounting.

The electrical connection framework 2 is connected to the first connector 11 and the second connector 12, and the second connector 12 is connected to a vehicle-mounted battery, thereby completing an electrical transmission from the first connector 11 to the vehicle-mounted battery. When the vehicle is charged, the current flowing through the electrical connection framework 2 is very large, leading to a rapid increase in the temperature of the electrical connection framework 2. The electrical connection framework 2 is provided with at least one hollow inner cavity 3 through which the cooling liquid flows to cool the electrical connection framework 2, thereby reducing the temperature of the electrical connection framework 2 which generates heat, and enabling the connector assembly to work at a safe temperature. In addition, since the electrical connection framework 2 is provided with at least one hollow inner cavity 3, the electrical connection framework 2 may be made of a rigid hollow conductor material to form the hollow inner cavity 3. Therefore, the present disclosure solves the problem that the automatic production and assembling cannot be realized because the high-voltage wire harness uses the flexible cable at present. The automatic fitting and assembling of the wire harness can be realized using the rigid electrical connection framework. Meanwhile, the present disclosure also solves the problem that the flexible cable contacts and rubs the vehicle shell, resulting in the damage and short circuit of the insulation layer. The rigid electrical connection framework can be arranged according to the shape of a vehicle body, while keeping a distance from the vehicle body to avoid rubbing the vehicle shell, thereby ensuring the service life of the electrical connection framework 2.

Furthermore, in order to reduce the heating degree of the electrical connection framework 2, the cooling liquid or cooling oil also flows through the hollow inner cavity 3.

In some embodiments, as illustrated in FIG. 2, the electrical connection framework 2 is provided with one hollow inner cavity 3, and the hollow conductor has a uniform wall thickness.

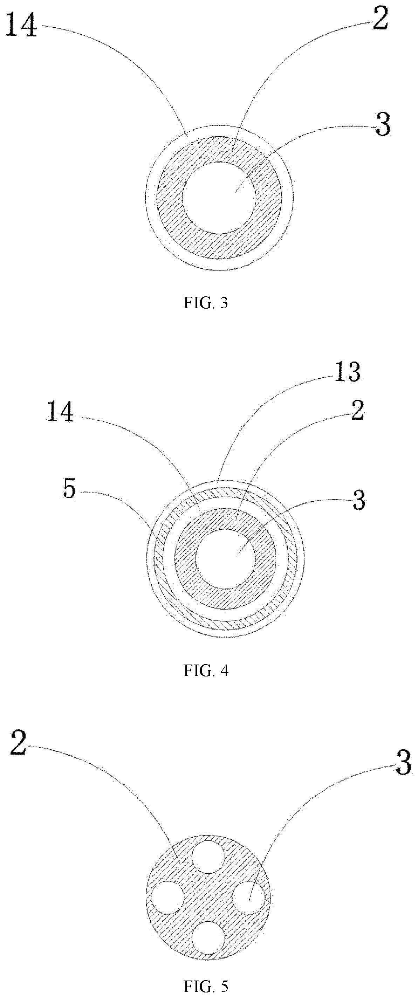

In some embodiments, the electrical connection framework 2 is provided with a plurality of hollow inner cavities 3 distributed in the electrical connection framework 2. Specifically, as illustrated in FIG. 5, the electrical connection framework 2 is provided with four hollow inner cavities 3, which are distributed in the electrical connection framework 2 in a circumferential direction. Exemplarily, the hollow inner cavities 3 may be uniformly distributed in the electrical connection framework 2. Of course, it can be understood that in other embodiments, the number of the hollow inner cavities 3 is not limited to four, and may be set according to actual needs.

Further, in some embodiments, a cross-sectional area of the electrical connection framework 2 is 1.5 mm² to 240 mm². The cross-sectional area of the electrical connection framework 2 determines the current that can be conducted by the electrical connection framework 2. Generally, the electrical connection framework 2 that realizes signal conduction has a small current and a small cross-sectional area. For example, a minimum cross-sectional area of the electrical connection framework 2 of the wires for signal transmission may be 1.5 mm². The electrical connection framework 2 that realizes power conduction has a large current and a large cross-sectional area. For example, a maximum cross-sectional area of a conductor of a vehicle battery wire harness may reach 240 mm².

In some embodiments, a sum of the cross-sectional areas of the hollow inner cavities 3 accounts for 3.7% to 75% of a cross-sectional area of a circumscribed circle of the electrical connection framework 2. If the sum of the cross-sectional areas is too large, a supporting force of the electrical connection framework 2 will be insufficient, and if the sum of the cross-sectional areas is too small, the cooling effect will be insufficient. In order to select a reasonable sum of the cross-sectional areas of the hollow inner cavities 3, the inventor carries out relevant tests. The experimental method is to select the electrical connection frameworks 2 with different numbers of the hollow inner cavities 3, apply a force of 80 N to observe whether the electrical connection framework 2 is bent, and it is unqualified if bent. In a closed environment, the same current is conducted to the electrical connection frameworks 2 with different numbers of the hollow inner cavities 3, and a temperature rise less than 50K is a qualified value. The results are shown in Table 1.

**Table 1: Influence of the ratio of the sum of the cross-sectional areas of the hollow inner cavities 3 to the cross-sectional area of the circumscribed circle of the electrical connection framework 2 on the support to and the temperature rise of the electrical connection framework 2**

| Ratio of the sum of the cross-sectional areas of the hollow inner cavities 3 to the cross-sectional area of the circumscribed circle of the electrical connection framework 2 (%) | | | | | | | | | | | | |
|---|---|---|---|---|---|---|---|---|---|---|---|---|
| 2 | 2.5 | 3 | 3.5 | 3.7 | 4 | 15 | 30 | 45 | 60 | 64 | 75 | 78 |

| Whether the electrical connection framework 2 is bent | | | | | | | | | | | | |
|---|---|---|---|---|---|---|---|---|---|---|---|---|
| No | No | No | No | No | No | No | No | No | No | No | No | Yes |

| Temperature rise of the electrical connection framework 2 (K) | | | | | | | | | | | | |
|---|---|---|---|---|---|---|---|---|---|---|---|---|
| 52.2 | 51 | 50.5 | 50.2 | 48.2 | 45.8 | 38.5 | 37.1 | 33.2 | 30.9 | 27.5 | 27.4 | 27.4 |

As can be seen from Table 1, when the ratio of the sum of the cross-sectional areas of the hollow inner cavities 3 to the cross-sectional area of the electrical connection framework 2 is less than 3.7%, the temperature rise of the electrical connection framework 2 is greater than 50K, which is unqualified. When the ratio of the sum of the cross-sectional areas of the hollow inner cavities 3 to the cross-sectional area of the electrical connection framework 2 is greater than 75%, the electrical connection framework 2 will be deformed under the force of 80 N, which will easily lead to the leakage of the cooling liquid. Therefore, the inventor prefers that the ratio of the sum of the cross-sectional areas of the hollow inner cavities 3 to the cross-sectional area of the electrical connection framework 2 is 3.7% to 75%.

In some embodiments, a cross-sectional shape of an outer contour of the electrical connection framework 2 is one or more selected from the group consisting of a circular shape, an elliptical shape, a rectangular shape, a polygonal shape, an A shape, a B shape, a D shape, an M shape, an N shape, an O shape, an S shape, an E shape, an F shape, an H shape, a K shape, an L shape, a T shape, a U shape, a V shape, a W shape, an X shape, a Y shape, a Z shape, a P shape, a semi-arc shape, an arc shape and a wavy shape.

Specifically, one part of a cross section of the electrical connection framework 2 may be a circular structure, and the other part thereof may be an elliptical structure. The electrical connection framework 2 is specifically a rod conductor with a large diameter. In case of a narrow space during wiring, the design of the structure can better adapt to a wiring path of the vehicle without changing the power transmission effect. However, in the prior art, usually two different wires are used to match the vehicle body by means of adaption such as welding or crimping. Therefore, the design of the solution effectively reduces the cost, better matches the contour of the vehicle body, simplifies the wiring process, reduces wiring consumables and improves the mounting efficiency.

In some embodiments, a partial region of the electrical connection framework 2 is flexible. The flexible material may be a multi-core cable, or a braided cable, or a soft bar formed with a plurality of layers of sheets which are stacked. The flexible material is easy to be bent and has excellent electrical conductivity; the sheet is soft, easy to be deformed and suitable to be used as a flexible conductor; and the stacking of the plurality of layers of sheets ensures not only the flexibility but also the electrification efficiency. The electrical connection framework 2 is formed by connecting the rigid material and the flexible material, so as to better fit the contour of the vehicle body according to the mounting environment of the vehicle body. By reasonably designing the structure of the connector assembly, the mounting of the connector assembly on the vehicle body is easier, and the material and the space can be saved.

In some embodiments, the electrical connection framework 2 includes at least one bent portion. Therefore, the bent portion may be disposed according to the specific requirements in the wiring process, so as to facilitate the wiring by the operator.

In some embodiments, as illustrated in FIG. 3, an outer periphery of the electrical connection framework 2 is sleeved with an insulation layer 14, which can prevent the contact and short circuit between the electrical connection framework 2 and the vehicle shell.

Further, as illustrated in FIG. 4, the insulation layer 14 is sequentially sleeved with a shielding layer 5 and an outer insulation layer 13. The shielding layer 5 can reduce the interference of electromagnetic radiation generated by the electrical connection framework 2 to other electrical devices in the vehicle. Since the shielding layer 5 is made of a conductor and should be grounded, the insulation layer 14 is disposed between the shielding layer 5 and the electrical connection framework 2 to prevent a contact therebetween. The outer insulation layer 13 can prevent the contact and short circuit between the shielding layer 5 and the vehicle shell.

In some embodiments, the first connector 11 and the second connector 12 further include a shielding inner shell 4 made of a conductive material. Therefore, by disposing the shielding inner shell 4 inside the connector, it is possible to effectively prevent the electromagnetic interference generated by the terminal of the connector.

In order to reduce the influence of the electromagnetic interference, the conductive cable usually uses a shielding net to shield the electromagnetic interference. At present, the conventional shielding net is braided with metal wires, and a shielding braiding machine has to be added in the cable production equipment, such that the equipment price is high and a large area is occupied, resulting in a high price of the shielding cable of the connector. In the present disclosure, the shielding inner shell 4 made of a conductive material is electrically connected to the shielding layer 5 to form a complete shielding device. The shielding layer 5 is made of a rigid conductive material. Further, the material of the shielding layer 5 may be metal or conductive plastic. Therefore, the shielding inner shell 4 and the shielding layer 5 may have a shielding function to effectively shield the electromagnetic interference caused by the electrification of the electrical connection framework 2, thereby saving the use of the shielding net and reducing the cost of the connector assembly.

In some embodiments, the shielding inner shell 4 has a transfer impedance less than 100 mΩ. In order to verify the influence of different transfer impedances of the shielding inner shell 4 on the shielding effects, the inventor selects the electrical connection frameworks 2 with the same specification, the connectors with the same specification, the connection terminals 7 with the same specification, and the shielding inner shells 4 with different transfer impedances to make a series of samples, so as to test the shielding effects respectively. The experimental results are shown in Table 2. In this embodiment, the shielding performance value greater than 40dB is an ideal value.

The test method of the shielding performance value is to adopt a test instrument that outputs a signal value (which is a test value 2) to the electrical connection framework 2, and dispose a detection device which detects a signal value (which is a test value 1) outside the shielding inner shell 4. The shielding performance value = the test value 2 - the test value 1.

**Table 2: Influence of the transfer impedance of the shielding inner shell 4 on the shielding performance**

| Test parameter | Transfer impedance of the shielding inner shell 4 (mΩ) | | | | | | | | | | |
|---|---|---|---|---|---|---|---|---|---|---|---|
| | 20 | 30 | 40 | 50 | 60 | 70 | 80 | 90 | 100 | 110 | 120 |
| Shielding performance value (dB) | 79 | 76 | 71 | 66 | 63 | 58 | 55 | 46 | 42 | 31 | 27 |

As can be seen from Table 2, when the transfer impedance of the shielding inner shell 4 is greater than 100 mΩ, the shielding performance value of the shielding inner shell 4 is less than 40 dB, which does not meet the requirement of the ideal value. When the transfer impedance of the shielding inner shell 4 is less than 100 mΩ, all of the shielding performance values of the shielding inner shell 4 meet the requirement of the ideal value, and the trend is increasingly better. Therefore, the inventor sets the transfer impedance of the shielding inner shell 4 to be less than 100 mΩ.

Further, the material of the shielding inner shell 4 contains metal or conductive plastic. The conductive plastic may be a polymer material containing conductive particles, and the conductive particles are made of a material including one or more selected from the group consisting of metal, conductive ceramics, a carbon-containing conductor, a solid electrolyte and a mixed conductor. The material of the polymer material includes one or more selected from the group consisting of tetraphenyl ethylene, polyvinyl chloride, polyethylene, polyamide, polytetrafluoroethylene, tetrafluoroethylene/hexafluoropropylene copolymer, ethylene/tetrafluoroethylene copolymer, polypropylene, polyvinylidene fluoride, polyurethane, polyterephthalic acid, polyurethane elastomer, styrene block copolymer, perfluoroalkoxy alkane, chlorinated polyethylene, polyphenylene sulfide, polystyrene, cross-linked polyolefin, ethylene-propylene rubber, ethylene/vinyl acetate copolymer, chloroprene rubber, natural rubber, styrene butadiene rubber, nitrile rubber, silicone rubber, butadiene rubber, isoprene rubber, ethylene propylene rubber, chloroprene rubber, butyl rubber, fluororubber, polyurethane rubber, polyacrylate rubber, chlorosulfonated polyethylene rubber, epichlorohydrin rubber, chlorinated polyethylene rubber, chlorosulfide rubber, styrene butadiene rubber, butadiene rubber, hydrogenated nitrile rubber, polysulfide rubber, crosslinked polyethylene, polycarbonate, polysulfone, polyphenyl ether, polyester, phenolic resin, urea formaldehyde, styrene-acrylonitrile copolymer, polymethacrylate, and polyoxymethylene resin.

The advantage of the conductive plastic is to facilitate the injection molding, and the user can select the shielding inner shell 4 made of an appropriate material as needed.

Further, the metal in the material of the conductive particles contains one or more selected from the group consisting of nickel, cadmium, zirconium, chromium, cobalt, manganese, aluminum, tin, titanium, zinc, copper, silver, gold, phosphorus, tellurium and beryllium.

In order to verify the influence of different metal materials on the electrical conductivity of the shielding inner shell 4, the inventor makes samples of the shielding inner shell 4 with metal particles of the same size and different materials to test the electrical conductivity of the shielding inner shell 4. The experimental results are shown in Table 3. In this embodiment, the electrical conductivity of the shielding inner shell 4 greater than 99% is an ideal value.

**Table 3: Influence of metal particles made of different materials on the electrical conductivity of the shielding inner shell 4**

| Metals of different materials | | | | | | | | | | | | | | | |
|---|---|---|---|---|---|---|---|---|---|---|---|---|---|---|---|
| Gold | Silver | Copper | Nickel | Titanium | Tin | Aluminum | Cadmium | Zirconium | Chromium | Cobalt | Manganese | Zinc | Tellurium | Beryllium | Palladium |

| Electrical conductivity of the shielding inner shell 4 (%) | | | | | | | | | | | | | | | |
|---|---|---|---|---|---|---|---|---|---|---|---|---|---|---|---|
| 99.8 | 99.9 | 99.8 | 99.5 | 99.5 | 99.5 | 99.6 | 99.3 | 99.2 | 99.2 | 99.4 | 99.5 | 99.3 | 99.4 | 99.4 | 99.2 |

As can be seen from Table 3, the electrical conductivity of the conductive plastic made of different selected metal particles is within the range of the ideal value. In addition, phosphorus is a non-metallic material and cannot be directly used as the material of the conductive plating layer, but it can be added to other metal to form an alloy to improve the conductive and mechanical properties of the metal itself. Therefore, the inventor sets that the material of the metal particles contains one or more selected from the group consisting of nickel, cadmium, zirconium, chromium, cobalt, manganese, aluminum, tin, titanium, zinc, copper, silver, gold, phosphorus, tellurium and beryllium.

Further, the carbon-containing conductor in the material of the conductive particles may contain one or more selected from the group consisting of graphite silver, graphene silver, graphite powder, a carbon nanotube material and a graphene material. The graphite powder is a mineral powder with the main component of carbon, which is soft and dark gray and is a very good nonmetallic conductive substance. The carbon nanotube has good electrical conductivity, with a structure the same as the lamellar structure of graphite, so it has good electrical properties. Graphene has extremely high electrical properties. The carbon-containing conductor containing these three materials has high electrical conductivity and good shielding performance, which can well realize the electromagnetic shielding of the electrical connection framework 2.

In some embodiments, the shielding inner shell 4 made of conductive plastic can be integrally formed with the connector by means of integral injection molding, which saves the machining time, improves the production efficiency and reduces the production cost.

In some embodiments, the material of the connection terminal 7 may be copper or copper alloy, the material of the electrical connection framework 2 may be aluminum or aluminum alloy, and the electrical connection framework 2 is electrically connected to the connection terminal 7 by means of welding or crimping.

Copper or copper alloy has high electrical conductivity and friction resistance, and at present, the power connection parts of most of the electrical devices are made of copper, so the connection terminal 7 may be made of copper or copper alloy for plugging and unplugging connection, and the connection terminal 7 can be widely used in various electrical transmission scenarios.

The electrical connection framework 2 made of aluminum or aluminum alloy has the advantages of good rigidity, light weight and high transmission efficiency, and is especially suitable for the transmission of large current.

The connection terminal 7 and the electrical connection framework 2 are connected by welding. The welding modes, which include one or more selected from the group consisting of resistance welding, friction welding, ultrasonic welding, arc welding, laser welding, electron beam welding, pressure diffusion welding and magnetic induction welding, use the concentrated heat energy or pressure to achieve a fusion connection at the contact positions of the connection terminal 7 and the electrical connection framework 2, such that the connection by welding is stable.

In addition, the metal inertia of copper is greater than that of aluminum, and an electrode potential difference between copper and aluminum is 1.9997 V. An electrochemical reaction will occur when the two metals are connected and electrified, which will lead to a gradual oxidation of aluminum wires, reducing the mechanical strength and the electrical conductivity of aluminum wires. Dissimilar materials can be connected by welding, and the conductive effect is better since the contact positions are fused.

The resistance welding refers to a method of welding by passing strong current through a contact point that is between an electrode and a workpiece, to generate heat by a contact resistance.

The friction welding refers to a method of welding by using the heat generated by the friction between the contact surfaces of the workpieces as a heat source, to make the workpieces be plastically deformed under pressure.

The ultrasonic welding is to transmit high-frequency vibration waves to surfaces of two to-be-welded objects, so that the surfaces of the two objects rub against each other under pressure to form a fuse molecular layer.

The arc welding is to convert electric energy into heat energy and mechanical energy that are needed for welding by using electric arc as a heat source and using the physical phenomenon of air discharge, so as to connect metals. The arc welding mainly includes shielded metal arc welding, submerged arc welding and gas shielded welding, etc.

The laser welding is an efficient and precise welding method that uses a laser beam with high energy density as a heat source.

The friction welding refers to a method of welding by using the heat generated by the friction between the contact surfaces of the workpieces as a heat source, to make the workpieces be plastically deformed under pressure.

The electron beam welding method refers to a method of using accelerated and focused electron beam to bombard the welding surface that is placed in vacuum or non-vacuum, to melt the welded workpiece to achieve welding.

The pressure welding method is a method of applying pressure to weldments to make binding surfaces of them be in close contact and generate a certain plastic deformation to complete the welding.

The magnetic induction welding refers to that that two to-be-welded workpieces are instantaneously collided with each other at high speed under the action of a strong pulsed magnetic field, so that under the action of high pressure waves, the atoms of the two materials on the material surfaces of the two workpieces can meet within interatomic distance, thus forming a stable metallurgical bond at the interface. The magnetic induction welding is a type of solid-state cold welding that can weld conductive metals with similar or dissimilar properties.

The crimping is a production process in which the electrical connection framework 2 and the connection terminal 7 are assembled and then stamped into a whole using a crimping machine. The crimping has the advantage of mass production, and by adopting an automatic crimping machine, products with a stable quality can be rapidly manufactured in large quantities.

In some embodiments, the shielding layer 5 is electrically connected to the shielding inner shell 4 by crimping or welding. Aluminum or aluminum alloy has good electrical conductivity, light weight and low price. The shielding inner shell 4 made of aluminum or aluminum alloy can achieve a good shielding effect and prevent the electromagnetic radiation of the connection terminal 7 and the electrical connection framework 2 from affecting other devices.

The crimping is a production process in which the shielding inner shell 4 and the shielding layer 5 are assembled and then stamped into a whole using a crimping machine. The crimping has the advantage of mass production, and by adopting an automatic crimping machine, products with a stable quality can be rapidly manufactured in large quantities.

The welding or crimping is substantially the same as the welding mode for the connection terminal 7 and the electrical connection framework 2, and will not be described in detail.

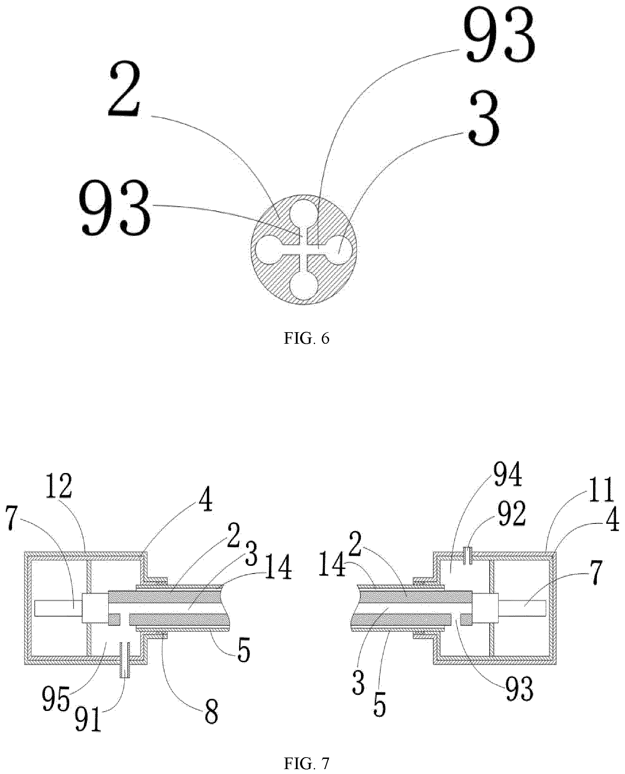

In some embodiments, as illustrated in FIG. 7, the electrical connector assembly having a liquid cooling function of the present disclosure includes one electrical connection framework 2, and a first connector 11 and a second connector 12 which are connected to two ends of the electrical connection framework 2; the first connector 11 is internally provided with a rotary cavity 94, the second connector 12 is internally provided with an adapter cavity 95, and the rotary cavity 94 and the adapter cavity 95 are communicated with one of the hollow inner cavities 3 of the electrical connection framework 2, respectively.

In addition, specifically, one of the first connector 11 and the second connector 12 is provided with an inlet pipe 91 communicated with one of the rotary cavity 94 and the adapter cavity 95; the other of the first connector 11 and the second connector 12 is provided with an outlet pipe 92 communicated with the other of the rotary cavity 94 and the adapter cavity 95. That is, in this embodiment, as illustrated in FIG. 7, the inlet pipe 91 is disposed on the second connector 12 and communicated with the adapter cavity 95; the outlet pipe 92 is disposed on the first connector 11 and communicated with the rotary cavity 94. Of course, it can also be understood that in other embodiments, the inlet pipe 91 is disposed on the first connector 11 and communicated with the rotary cavity 94, and the outlet pipe 92 is disposed on the second connector 12 and communicated with the adapter cavity 95.

Therefore, driven by a circulating pump, the cooling liquid may enter the hollow inner cavity 3 of the electrical connection framework 2 from one end of the electrical connection framework 2 (such as from the second connector 12) via the inlet pipe 91, and after flowing through the hollow inner cavity 3, flow out of the outlet pipe 92 to be cooled by a cooling system, then enter the hollow inner cavity 3 again driven by the circulating pump, thereby forming a complete cooling cycle.

In some embodiments, a part of the electrical connection framework 2 inside the rotary cavity 94 and a part thereof inside the adapter cavity 95 are both radially provided with through holes 93, via which the cooling liquid flows through the rotary cavity 94, the hollow inner cavity 3 and the adapter cavity 95.

Specifically, as illustrated in FIG. 7, a part of the electrical connection framework 2 inside the rotary cavity 94 is radially provided with a through hole 93, via which the cooling liquid flows through the hollow inner cavity 3 and the rotary cavity 94.

Specifically, as illustrated in FIG. 7, a part of the electrical connection framework 2 inside the adapter cavity 95 is radially provided with a through hole 93, via which the cooling liquid flows through the hollow inner cavity 3 and the adapter cavity 95.

Therefore, the cooling liquid can flow through the rotary cavity 94, the hollow inner cavity 3 and the adapter cavity 95 via the through holes 93.

More specifically, as illustrated in FIG. 7, the inlet pipe 91 is inserted into the adapter cavity 95 of the second connector 12 and communicated with the hollow inner cavity 3; and the outlet pipe 92 is inserted into the rotary cavity 94 of the first connector 11 and communicated with the hollow inner cavity 3.

However, in some other unillustrated embodiments, the inlet pipe and the outlet pipe each may have one end in matched connection with the through hole of the electrical connection framework, and the other end passing through outer walls of the first connector and the second connector and protruding out of the first connector and the second connector. Therefore, the cooling liquid can communication with the hollow inner cavity without having to fill up the rotary cavity and the adapter cavity 95.

Further, in some other unillustrated embodiments, the electric connector assembly having a liquid cooling function of the present disclosure may be provided with two (or more) electrical connection frameworks, and a first connector and a second connector connected to two ends of each of the electrical connection frameworks. Each of the first connector and the second connector is provided with a connection terminal connected to two ends of each of the electrical connection frameworks respectively. Specifically, the electrical connection framework may be only provided with one hollow inner cavity 3 as illustrated in FIG. 2. Of course, it can be understood that the electrical connection framework may be also provided with a plurality of hollow inner cavities 3 as illustrated in FIG. 5. Therefore, in a case where the electrical connection framework is provided with a plurality of hollow inner cavities, as illustrated in FIG. 6, the through holes 93 communicated with each other may be disposed between the hollow inner cavities 3, so as to ensure that the cooling liquid can flow through each of the hollow inner cavities in one electrical connection framework.

Further, in some embodiments, for example in a case where the inlet pipe 91 and the outlet pipe 92 are connected to the through holes 93 on the electrical connection framework 2, instead of directly connected to the rotary cavity 94 or the adapter cavity 95, connection holes may be disposed between the electrical connection frameworks 2, so that the cooling liquid can flow through each of the hollow inner cavities 3 via the connection holes and the through holes 93, so as to realize the communication between the hollow inner cavities 3 of two or more electrical connection frameworks 2.

In some embodiments, a first sealing structure is disposed between the inlet pipe 91 and one of the first connector 11 and the second connector 12; and a second sealing structure is disposed between the outlet pipe 92 and the other of the first connector 11 and the second connector 12.

Specifically, in some embodiments, a first sealing structure is disposed between the inlet pipe 91 and the second connector 12. The first sealing structure may be a sealing ring. Similarly, a second sealing structure may be disposed between the outlet pipe 92 and the first connector 11. The second sealing structure may be the same as the first sealing structure. Of course, it can also be understood that in other embodiments, the second sealing structure is different from the first sealing structure.

In some embodiments, a third sealing structure is disposed between the connector and the shielding layer 5. Specifically, in some embodiments, as illustrated in FIG. 7, a sealing ring 8 (which can be understood as a third sealing structure) is disposed between the first connector 11 or the second connector 12 and the shielding layer 5. The sealing ring 8 seals the rotary cavity 94 and the adapter cavity 95. The sealing ring 8 can prevent the leakage of the cooling liquid from a joint between the first connector 11 or the second connector 12 and the shielding layer 5.

In some embodiments, a cooling medium is cooling gas or cooling liquid. The cooling gas may be refrigerated air. The cooling liquid may be one or more selected from the group consisting of water, ethylene glycol, silicone oil, fluoride, castor oil, coconut oil, corn oil, cottonseed oil, linseed oil, olive oil, palmitic acid, peanut oil, grapeseed oil, rapeseed oil, safflower oil, sunflower oil, soybean oil, high oleic acid variants of various vegetable oils, decen-4-oic acid, decenoic acid, lauroleic acid, linderic acid, tetradecenoic acid, physeteric acid, tsuduic acid, palmitoleic acid, petroselic acid, oleic acid, octadecenoic acid, gondoic acid, cetoleic acid, erucic acid, nervonic acid, glycerin, transformer oil, axle oil, internal combustion engine oil or compressor oil. An additive may also be added into the cool liquid, and the additive is selected from one or more selected from the group consisting of an antioxidant, a pour point inhibitor, a corrosion inhibitor, an antibacterial agent and a viscosity modifier. A boiling point of the cooling liquid may be greater than or equal to 100°C. The cooling oil has the advantages of sensitive heat balance capability, super-strong heat conduction capability, super-wide working temperature range, no boiling, micro-pressure of the cooling system, no addition of antifreeze in a low-temperature environment, and no corrosion damage such as cavitation, liquid scale, electrolysis or the like.

In some embodiments, the cooling rate of the cooling liquid to the electrical connection framework 2 is 0.05 K/s to 5 K/s. In order to verify the influence of the cooling rate of the cooling liquid on the temperature rise of the electrical connection framework 2, the inventor selects ten electrical connection frameworks 2 with the same cross-sectional area, the same material and the same length and conducts the same current thereto, cools the electrical connection frameworks 2 with the cooling liquid of different cooling rates, reads and records the temperature rise of each of the electrical connection frameworks 2 in Table 4.

The experimental method is to conduct the same current, in a closed environment, to each of the electrical connection frameworks 2 which adopts the cooling liquid of different cooling rates, record a temperature before the current conduction and a stable temperature after the current conduction, and take an absolute value of a difference therebetween. In this embodiment, a temperature rise less than 50 K is a qualified value.

**Table 4: Influence of different cooling rates of the cooling liquid on the temperature rise of the connection terminal 7**

| Cooling rate of the cooling structure (K/min) | | | | | | | | | | | | |
|---|---|---|---|---|---|---|---|---|---|---|---|---|
| 0.01 | 0.03 | 0.05 | 0.1 | 0.3 | 0.5 | 1 | 2 | 3 | 4 | 5 | 6 | 7 |

| Temperature rise of the connection terminal (K) | | | | | | | | | | | | |
|---|---|---|---|---|---|---|---|---|---|---|---|---|
| 63.0 | 54.5 | 49.6 | 45.7 | 44.1 | 43.5 | 41.4 | 37.7 | 33.3 | 30.9 | 27.5 | 27.5 | 27.4 |

As can be seen from Table 4, when the cooling rate is less than 0.05 K/s, the temperature rise of the electrical connection framework 2 is unqualified, and the temperature rise of the electrical connection framework 2 decreases as the cooling rate increases. However, when the cooling rate of the cooling liquid is greater than 5 K/s, the temperature rise of the electrical connection framework 2 is not obviously decreased, and a higher cooling rate means a higher price and a more complicated process, so the inventor sets the cooling rate of the cooling structure as 0.05 K/s to 5 K/s.

In some embodiments, one of the connectors is a charging cradle. The two ends of the electrical connection framework 2 are connected to one connector respectively. In some cases, one connector (e.g., the first connector 11) may be a charging cradle that charges the other connector (e.g., the second connector 12) through the electrical connection framework 2.

In some embodiments, a partial region of the electrical connection framework 2 is flexible. A flexible body ensures that the electrical connection framework 2 can be bent at a large angle, so as to be conveniently disposed in the vehicle body with a large corner. Meanwhile, the flexible body can absorb the vibration of the electrical connection framework 2, so that the vibration of the electrical connection framework 2 will not affect the connector and other corresponding electrical devices on the vehicle body.

In some embodiments, the electrical connection framework 2 includes at least one bent portion to meet the requirement of mounting the electrical connection framework 2 on the vehicle body.

The present disclosure further provides a vehicle, which includes the aforementioned connector assembly having a liquid cooling function, a circulating pump and a cooling device, and the hollow inner cavity 3 is communicated with the circulating pump and the cooling device.

More specifically, in some embodiments, an inlet pipe 91 is communicated with a liquid inlet of the circulating pump, a liquid outlet of the circulating pump is communicated with an liquid inlet of the cooling device, and a liquid outlet of the cooling device is communicated with an outlet pipe 92 that is communicated with the hollow inner cavity 3.

Although some specific embodiments of the present disclosure have been described in detail by examples, it should be understood by those skilled in the art that the above examples are only for illustration rather than limiting the scope of the present disclosure. It should be understood by those skilled in the art that the above embodiments can be modified without departing from the scope and the spirit of the present disclosure. The scope of the present disclosure is defined by the appended claims.

## Claims

1. A connector assembly having a liquid cooling function, comprising at least one electrical connection framework and connectors, wherein each connector comprises a connection terminal, two ends of the electrical connection framework are electrically connected to the connection terminals respectively, and the electrical connection framework is provided with at least one hollow inner cavity, through which a cooling liquid flows.

2. The connector assembly having a liquid cooling function according to claim 1, wherein the cooling liquid is made of an insulating material.

3. The connector assembly having a liquid cooling function according to claim 1, wherein the electrical connection framework comprises a rigid hollow conductor.

4. The connector assembly having a liquid cooling function according to claim 1, wherein the electrical connection framework is electrically connected to the connection terminal by means of welding or crimping.

5. The connector assembly having a liquid cooling function according to claim 1, wherein an outer contour of the electrical connection framework has a cross section of one or more selected from the group consisting of a circular shape, an elliptical shape, a rectangular shape, a polygonal shape, an A shape, a B shape, a D shape, an M shape, an N shape, an O shape, an S shape, an E shape, an F shape, an H shape, a K shape, an L shape, a T shape, a U shape, a V shape, a W shape, an X shape, a Y shape, a Z shape, a P shape, a semi-arc shape, an arc shape and a wavy shape.

6. The connector assembly having a liquid cooling function according to claim 3, wherein when the electrical connection framework is provided with one hollow inner cavity, the hollow conductor has a uniform wall thickness.

7. The connector assembly having a liquid cooling function according to claim 3, wherein a cross-sectional area of the hollow conductor is 1.5 mm² to 240 mm².

8. The connector assembly having a liquid cooling function according to claim 1, wherein a sum of cross-sectional area of the at least one hollow inner cavity accounts for 3.7% to 75% of a cross-sectional area of a circumscribed circle of the electrical connection framework.

9. The connector assembly having a liquid cooling function according to claim 1, wherein the connector further comprises a shielding inner shell, and a material of the shielding inner shell contains a conductive material.

10. The connector assembly having a liquid cooling function according to claim 9, wherein a material of the shielding inner shell contains metal or conductive plastic.

11. The connector assembly having a liquid cooling function according to claim 10, wherein the conductive plastic is a polymer material containing conductive particles, and the conductive particles are made of a material containing one or more selected from the group consisting of metal, conductive ceramics, a carbon-containing conductor, a solid electrolyte and a mixed conductor; and
the polymer material contains one or more selected from the group consisting of tetraphenyl ethylene, polyvinyl chloride, polyethylene, polyamide, polytetrafluoroethylene, tetrafluoroethylene/hexafluoropropylene copolymer, ethylene/tetrafluoroethylene copolymer, polypropylene, polyvinylidene fluoride, polyurethane, polyterephthalic acid, polyurethane elastomer, styrene block copolymer, perfluoroalkoxy alkane, chlorinated polyethylene, polyphenylene sulfide, polystyrene, cross-linked polyolefin, ethylene-propylene rubber, ethylene/vinyl acetate copolymer, chloroprene rubber, natural rubber, styrene butadiene rubber, nitrile rubber, silicone rubber, butadiene rubber, isoprene rubber, ethylene propylene rubber, chloroprene rubber, butyl rubber, fluororubber, polyurethane rubber, polyacrylate rubber, chlorosulfonated polyethylene rubber, epichlorohydrin rubber, chlorinated polyethylene rubber, chlorosulfide rubber, styrene butadiene rubber, butadiene rubber, hydrogenated nitrile rubber, polysulfide rubber, crosslinked polyethylene, polycarbonate, polysulfone, polyphenyl ether, polyester, phenolic resin, urea formaldehyde, styrene-acrylonitrile copolymer, polymethacrylate, and polyoxymethylene resin.

12. The connector assembly having a liquid cooling function according to claim 11, wherein a material of the metal contains one or more selected from the group consisting of nickel, cadmium, zirconium, chromium, cobalt, manganese, aluminum, tin, titanium, zinc, copper, silver, gold, phosphorus, tellurium and beryllium.

13. The connector assembly having a liquid cooling function according to claim 11, wherein the carbon-containing conductor contains one or more selected from the group consisting of graphite silver, graphene silver, graphite powder, a carbon nanotube material and a graphene material.

14. The connector assembly having a liquid cooling function according to claim 9, wherein a transfer impedance of the shielding layer is less than 100 mΩ.

15. The connector assembly having a liquid cooling function according to claim 1, wherein an outer periphery of the electrical connection framework is sleeved with an insulation layer.

16. The connector assembly having a liquid cooling function according to claim 9, wherein an outer periphery of the electrical connection framework is sleeved with an insulation layer, and an outer periphery of the insulation layer is further sleeved with a shielding layer and an outer insulation layer.

17. The connector assembly having a liquid cooling function according to claim 16, wherein the shielding layer is electrically connected to the shielding inner shell.

18. The connector assembly having a liquid cooling function according to claim 1, wherein the connector comprises a first connector and a second connector which are connected to two ends of the electrical connection framework; the first connector is internally provided with a rotary cavity, the second connector is internally provided with an adapter cavity, and the rotary cavity and the adapter cavity are communicated with the hollower inner cavity, respectively; one of the first connector and the second connector is provided with an inlet pipe, which is communicated with one of the rotary cavity and the adapter cavity; and the other of the first connector and the second connector is provided with an outlet pipe, which is communicated with the other of the rotary cavity and the adapter cavity.

19. The connector assembly having a liquid cooling function according to claim 18, wherein a part of the electrical connection framework inside the rotary cavity and a part thereof inside the adapter cavity are both radially provided with through holes, via which the cooling liquid flows through the rotary cavity, the hollow inner cavity and the adapter cavity.

20. The connector assembly having a liquid cooling function according to claim 19, wherein the inlet pipe and the outlet pipe each has one end in matched connection with the through hole, and the other end passing through outer walls of the first connector and the second connector and protruding out of the first connector and the second connector.

21. The connector assembly having a liquid cooling function according to claim 18, wherein a first sealing structure is disposed between the inlet pipe and one of the first connector and the second connector; and
a second sealing structure is disposed between the outlet pipe and the other one of the first connector and the second connector.

22. The connector assembly having a liquid cooling function according to claim 1, wherein a boiling point of the cooling liquid is greater than or equal to 100°C.

23. The connector assembly having a liquid cooling function according to claim 1, wherein the cooling liquid is one or more selected from the group consisting of ethylene glycol, silicone oil, fluoride, castor oil, coconut oil, corn oil, cottonseed oil, linseed oil, olive oil, palmitic acid, peanut oil, grapeseed oil, rapeseed oil, safflower oil, sunflower oil, soybean oil, high oleic acid variants of various vegetable oils, decen-4-oic acid, decenoic acid, lauroleic acid, linderic acid, tetradecenoic acid, physeteric acid, tsuduic acid, palmitoleic acid, petroselic acid, oleic acid, octadecenoic acid, gadoleic acid, gondoic acid, cetoleic acid, erucic acid, nervonic acid, glycerin, transformer oil, axle oil, internal combustion engine oil and compressor oil.

24. The connector assembly having a liquid cooling function according to claim 1, wherein a cooling rate of the cooling liquid to the electrical connection framework is 0.05 K/s to 5 K/s.

25. The connector assembly having a liquid cooling function according to claim 1, wherein one of the connectors is a charging cradle.

26. The connector assembly having a liquid cooling function according to claim 1, wherein a partial region of the electrical connection framework is flexible.

27. The connector assembly having a liquid cooling function according to claim 1, wherein the electrical connection framework comprises at least one bent portion.

28. A vehicle, comprising the connector assembly having a liquid cooling function according to any one of claims 1 to 27, a circulating pump and a cooling device, wherein the hollower inner cavity is communicated with the circulating pump and the cooling device.

29. The vehicle according to claim 28, wherein an inlet pipe in communication with the hollow inner cavity is communicated with a liquid inlet of the circulating pump, a liquid outlet of the circulating pump is communicated with a liquid inlet of the cooling device, and a liquid outlet of the cooling device is communicated with an outlet pipe that is communicated with the hollow inner cavity.
